# EUROPEAN PATENT SPECIFICATION

(11) **EP 3 032 743 B1**
(45) Date of publication and mention of the grant of the patent: **28.06.2017**
(21) Application number: 15198392.1
(22) Date of filing: 08.12.2015
(51) Int. Cl.: H03H 17/06, H04S 7/00, H03H 17/02

(54) **AUDIO SIGNAL PROCESSING CIRCUIT, CAR AUDIO APPARATUS, AUDIO COMPONENT APPARATUS, AND ELECTRONIC DEVICE**
AUDIOSIGNALVERARBEITUNGSSCHALTUNG, AUTOAUDIOVORRICHTUNG, AUDIOKOMPONENTENVORRICHTUNG UND ELEKTRONISCHE VORRICHTUNG
CIRCUIT DE TRAITEMENT DE SIGNAL AUDIO, APPAREIL AUDIO DE VOITURE, ÉLÉMENT AUDIO, APPAREIL ET DISPOSITIF ÉLECTRONIQUE

(30) Priority: 09.12.2014 JP 2014248809
(43) Date of publication of application: 15.06.2016
(73) Proprietor: Rohm Co., Ltd., Kyoto 615-8585 (JP)
(72) Inventor: YAMADA, Kenta, Kyoto 615-8585 (JP)
(74) Representative: Isarpatent

(56) References cited:
- WO-A1-89/05544
- JP-A- H0 423 609
- JP-A- H0 437 212

## Description

The present invention relates to an audio signal processing circuit, and particularly to a digital filter circuit.

Audio devices such as CD players, audio amplifiers, car stereo systems, portable audio players, portable radios, etc., and electronic devices having an audio playback function such as smartphones, tablet PCs, etc., each include a sound processor that performs various kinds of signal processing on a digital audio signal.

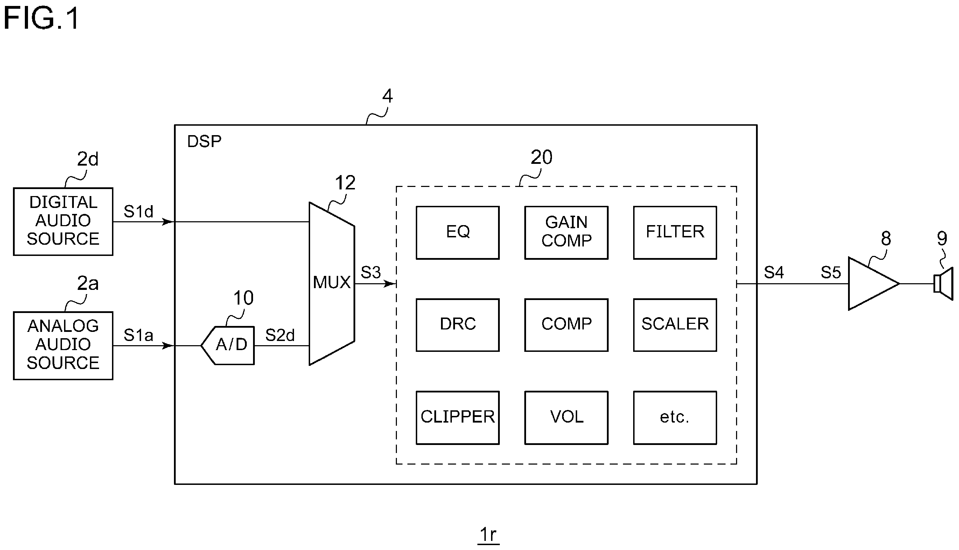

Fig. 1 is a block diagram showing an example configuration of an audio system. An audio system 1r includes a digital sound source 2d, an analog sound source 2a, a DSP (Digital Signal Processor or Digital Sound Processor) 4, a power amplifier 8, and an electroacoustic conversion element 9.

The digital sound source 2d generates a digital audio signal S1d, and outputs the digital audio signal S1d thus generated to the DSP 4 via a serial bus that conforms to the I²S (Inter IC Sound) standard. The digital sound source 2d may be configured as a CD (Compact Disc) player, a DVD (Digital Versatile Disc) player, or a BD (Blu-ray (trademark) Disc) player. Also, the sound source 2d may include an A/D converter that converts an analog audio signal into a digital audio signal. On the other hand, the analog sound source 2a outputs an analog audio signal S1a.

The DSP 4 receives the digital audio signal S1d or the analog audio signal S1a. An A/D converter 10 converts the analog audio signal S1a into a digital audio signal S2d. A multiplexer (selector) 12 receives the digital audio signals S1d and S2d, and selects one from among the digital audio signals S1d and S2d thus received. A digital signal processing unit 20 performs various kinds of digital signal processing on an audio signal S3 thus selected by the multiplexer 12.

Examples of such digital signal processing include: equalization (EQ), gain compensation (GAIN COMP), filtering (FILTER), dynamic range control (DRC), compression (COMP), scaling processing (SCALER), clipping processing (CLIPPER), digital volume control (VOL), monaural/stereophonic conversion, etc.

A digital audio signal S4 output from the digital signal processing unit 20 is converted into an analog audio signal S5 by means of an unshown D/A converter. The power amplifier 8 amplifies the analog audio signal S5 so as to drive a speaker or headphones configured as the electroacoustic conversion element 9. The power amplifier 8 may be configured as an analog amplifier or otherwise a digital amplifier.

In recent years, development is being advanced for high-resolution sound sources, i.e., sound sources each configured as a multi-bit sound source that operates with a high sampling rate. Thus, the DSP 4 is required to support such a high-resolution sound source. In order to provide high-quality sound, in many cases, the DSP 4 that supports such a high-resolution sound source mounts an FIR (finite impulse response) filter having a large circuit area instead of an IIR (infinite impulse response) filter. This becomes a factor that leads to an increased circuit area of the DSP 4. In addition, as such sound sources are improved to have a high resolution and multiple channels, the DSP 4 has been required to have a very large circuit scale. Patent documents listed below disclose the related arts.
[Patent Document 1]
   Japanese Patent Application Laid Open No. H04-37212
[Patent Document 2]
   Japanese Patent Application Laid Open No. 2004-128650

With conventional techniques, the DSP 4 vendor must design the DSP 4 for every sound source based on the number of channels of the sound source and the required sound quality. This leads to a problem of increased development costs and a problem of a long development period.

On the other hand, from the viewpoint of a user of the DSP 4, i.e., a designer of the audio system 1r, there is a need to select a suitable one from among multiple DSP items provided by the vendors based on the number of channels of the sound source and the required sound quality.

The present invention has been made in order to solve such a problem. Accordingly, it is an exemplary purpose of an embodiment of the present invention to provide an audio signal processing circuit that supports various numbers of channels and various required sound quality levels.

An embodiment of the present invention relates to an audio signal processing circuit. The audio signal processing circuit comprises: multiple N (N represents an integer of 2 or more) FIR (Finite Impulse Response) filters; multiple N first input ports that respectively correspond to the multiple N FIR filters; multiple N second input ports that respectively correspond to the multiple N FIR filters; multiple N first output ports that respectively correspond to the multiple N FIR filters; and multiple N second output ports that respectively correspond to the multiple N FIR filters. The first input ports, the second input ports, the first output ports, and the second output ports are integrated on a single semiconductor substrate. Each FIR filter comprises: a first input terminal; a second input terminal; a first output terminal; a second output terminal; multiple m (m represents an integer of 2 or more) delay elements connected in series between the first input terminal and the first output terminal; multiple multipliers that multiply, by predetermined coefficients, data at multiple taps provided to the m delay elements; and an adder circuit that outputs, via the second output terminal, product-sum data obtained by adding data input to the second input terminal and output data of the multiple multipliers. In the audio signal processing circuit, the i-th (2 ≤ i ≤ N) FIR filter is configured to be switchable between: (i) a state in which the i-th FIR filter receives, at its first input terminal, data output from the first output terminal of the (i-1)-th FIR filter, and receives, at its second input terminal, data output from the second output terminal of the (i-1)-th FIR filter; (ii) a state in which the i-th FIR filter receives, at its first input terminal, data of the i-th first input port, and receives, at its second input terminal, data of the i-th second input port; and (iii) a state in which the i-th FIR filter receives, at its first input terminal, the data of the i-th first input port, and receives zero at its second input terminal.

By combining such audio signal processing circuits, such an arrangement provides an optimum audio system according to the number of channels and the required sound quality.

Also, the audio signal processing circuit may further comprise: (N-1) first input multiplexers that correspond to the 2nd through N-th FIR filters; and (N-1) second input multiplexers that correspond to the 2nd through N-th FIR filters. Also, the i-th (2 ≤ i ≤ N) first input multiplexer may receive the data output from the first output terminal of the (i-1)-th FIR filter and the data of the i-th first input port, may select one from among the data thus received, and may output the data thus selected to the first input terminal of the i-th FIR filter. Also, the i-th (2 ≤ i ≤ N) second input multiplexer may receive the data output from the second output terminal of the (i-1)-th FIR filter and the data of the i-th second input port, and may output either one of the data thus received or otherwise zero to the second input terminal of the i-th FIR filter.

By employing such first and second input multiplexers, signal paths can be selected in units of FIR filters.

Also, the audio signal processing circuit may further comprise a controller that controls the (N-1) first input multiplexers and the (N-1) second input multiplexers.

Also, the audio signal processing circuit may further comprise a 1st first multiplexer that corresponds to the 1st FIR filter. Also, the 1st first input multiplexer may receive input data from another first circuit block included in the audio signal processing circuit and data of the 1st first input port, may select one from among the data thus received, and may output the data thus selected to the first input terminal of the 1st FIR filter.

With such an embodiment, in a case in which a different circuit block included within the audio signal processing circuit performs digital processing that differs from FIR filtering, such an arrangement is capable of selecting a signal output from the different circuit block as a filtering target.

Also, at least one FIR filter may be configured such that the data output from its second output terminal can be supplied to another second circuit block included within the audio signal processing circuit.

With such an embodiment, in a case in which a different circuit block included within the audio signal processing circuit performs digital processing that differs from FIR filtering, such an arrangement is capable of supplying data subjected to filtering to the different circuit block.

Also, the audio signal processing circuit may further comprise: N first receivers that correspond to the N first input ports, each of which receives the data of the corresponding first input port; and N second receivers that correspond to the N second input ports, each of which receives the data of the corresponding second input port.

Also, the audio signal processing circuit may comprise N first transmitters that correspond to the N FIR filters, each of which receives data output from the first output terminal of the corresponding FIR filter, and outputs the received data to the corresponding first output port; and N second transmitters that correspond to the N FIR filters, each of which receives data output from the second output terminal of the corresponding FIR filter, and outputs the received data to the corresponding second output port.

Another embodiment of the present invention relates to a car audio apparatus. The car audio apparatus comprises any one of the aforementioned audio signal processing circuits.

Yet another embodiment of the present invention relates to an audio component apparatus. The audio component apparatus comprises any one of the aforementioned audio signal processing circuits.

Yet another embodiment of the present invention relates to an electronic device. The electronic device comprises any one of the aforementioned audio signal processing circuits.

It should be noted that any combination of the aforementioned components, any component of the present invention, or any manifestation thereof, may be mutually substituted between a method, apparatus, system, and so forth, which are also effective as an embodiment of the present invention.

Embodiments will now be described, by way of example only, with reference to the accompanying drawings which are meant to be exemplary, not limiting, and wherein like elements are numbered alike in several Figures, in which:
Fig. 1 is a block diagram showing an example configuration of an audio system;
Fig. 2 is a block diagram showing an audio signal processing circuit according to an embodiment;
Figs. 3A through 3C are equivalent circuit diagrams showing the first state through the third state;
Figs. 4A through 4C are diagrams each showing a usage example of the audio signal processing circuit;
Fig. 5 is a block diagram showing an FIR chip and a main audio signal processing circuit that is to be operated together with the FIR chip;
Fig. 6 is a block diagram showing the audio signal processing circuit;
Fig. 7 is a diagram showing an example configuration of a part of the FIR block;
Fig. 8 is a block diagram showing a configuration of a car audio apparatus; and
Figs. 9A through 9C are external view of an electronic device or an audio component apparatus.

Description will be made below regarding preferred embodiments according to the present invention with reference to the drawings. The same or similar components, members, and processes are denoted by the same reference numerals, and redundant description thereof will be omitted as appropriate. The embodiments have been described for exemplary purposes only, and are by no means intended to restrict the present invention. Also, it is not necessarily essential for the present invention that all the features or a combination thereof be provided as described in the embodiments.

In the present specification, the state represented by the phrase "the member A is connected to the member B" includes a state in which the member A is indirectly connected to the member B via another member that does not affect the electric connection therebetween, in addition to a state in which the member A is physically and directly connected to the member B.

Similarly, the state represented by the phrase "the member C is provided between the member A and the member B" includes a state in which the member A is indirectly connected to the member C, or the member B is indirectly connected to the member C via another member that does not affect the electric connection therebetween, in addition to a state in which the member A is directly connected to the member C, or the member B is directly connected to the member C.

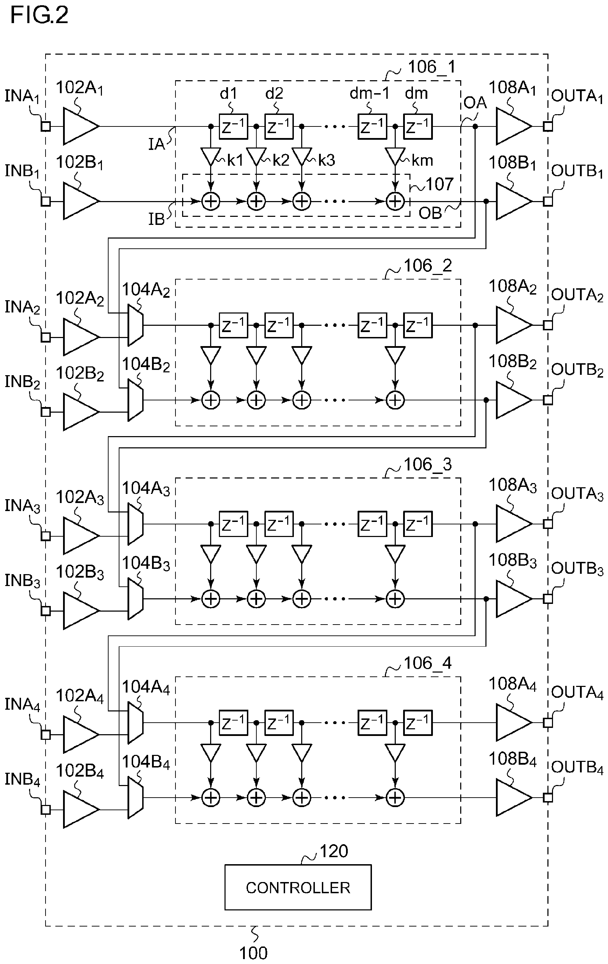

Fig. 2 is a block diagram showing an audio signal processing circuit 100 according to an embodiment. The audio signal processing circuit 100 includes multiple, i.e., N (N represents an integer of 2 or more) FIR filters 106, N first input ports INA, N second input ports INB, N first receivers 102A, N second receivers 102B, (N-1) first input multiplexers 104A, (N-1) second input multiplexers 104B, N first transmitters 108A, N second transmitters 108B, N first output ports OUTA, and N second output ports OUTB, which are integrated on a single semiconductor substrate. Description will be made in the present embodiment regarding an arrangement in which N = 4. Also, N may be a desired integer of 2 or more.

Examples of such a "integrated" arrangement include: an arrangement in which all the circuit components are formed on a semiconductor substrate; and an arrangement in which principal circuit components are monolithically integrated. Also, a part of the circuit components such as resistors and capacitors may be arranged in the form of components external to such a semiconductor substrate in order to adjust the circuit constants. By integrating the circuit as a single IC, such an arrangement allows the circuit area to be reduced, and allows the circuit elements to have uniform characteristics.

Each FIR filter 106 includes a first input terminal IA, a second input terminal IB, a first output terminal OA, a second output terminal OB, multiple, i.e., m (m represents an integer of 2 or more) delay elements d1 through dm, multiple multipliers K1 through Km, and an adder circuit 107. The m delay elements d1 through dm are connected in series between the first input terminal IA and the first output terminal OA. The multiple multipliers K1 through Km each multiply, by predetermined coefficients, the data at the corresponding one of multiple taps respectively provided to the m delay elements d1 through dm. The adder circuit 107 generates product-sum data configured as the result of adding the data input to the second input terminal IB and the output data output from the multiple multipliers K1 through Km, and outputs the product-sum data thus generated via the second output terminal OB.

Description will be made directing attention to the i-th (2 ≤ i ≤ N) FIR filter 106_i. The audio signal processing circuit 100 is configured to switch the input state of each FIR filter 106_i between three states.

### (i) First state φ1

In this state, the FIR filter 106_i receives, at its first input terminal IA, the data output from the first output terminal OA of the (i-1)-th FIR filter 106_(i-1), and receives, at its second input terminal IB, the data output from the second output terminal OB of the (i-1)-th FIR filter 106_(i-1).

### (ii) Second state φ2

In this state, the FIR filter 106_i receives, at its first input terminal IA, the data of the i-th first input port INAᵢ, and receives, at its second input terminal IB, the data of the i-th second input port INBᵢ.

### (iii) Third state φ3

In this state, the FIR filter 106_i receives, at its first input terminal IA, the data of the i-th first input port INAᵢ, and receives zero at its second input terminal IB.

The input state for the 1st FIR filter 106_1 is switchable between the second state φ2 and the third state φ3. That is to say, the input state for the 1st FIR filter 106_1 cannot be switched to the first state φ1.

In order to switch the input state between the first state φ1 through the third state φ3, the input multiplexers 104A and 104B are provided.

The i-th (2 ≤ i ≤ N) first input multiplexer 104Aᵢ receives the data output from the first output terminal OA of the (i-1)-th FIR filter 106_i and the data of the i-th first input port INAᵢ, selects one from among the data thus received, and outputs the data thus selected to the first input terminal IA of the i-th FIR filter 106_i.

The i-th (2 ≤ i ≤ N) second input multiplexer 104Bᵢ receives the data output from the second output terminal OB of the (i-1)-th FIR filter 106_i and the data of the i-th second input port INBᵢ, and outputs either one of these data or otherwise zero to the second input terminal IB of the i-th FIR filter 106_i.

A controller 120 controls the multiple first input multiplexers 104A, the multiple second input multiplexers 104B, the multiple first receivers 102A, and the multiple second receivers 102B. For example, the controller 120 includes memory or a register that stores control data configured as instructions to switch the state of each multiplexer and the state of each receiver, and a decoder that controls the state of each first multiplexer 104A, the state of each second input multiplexer 104B, the state of each first receiver 102A, and the state of each second receiver 102B, according to the control data.

The first receiver 102Aᵢ receives the data of the corresponding first input port INAᵢ, and outputs the data thus received to the corresponding input multiplexer 104Aᵢ. The second receiver 102Bᵢ receives the data of the corresponding second input port INBᵢ, and outputs the data thus received to the second input terminal IB of the corresponding FIR filter 106_i.

Furthermore, the first transmitter 108Aᵢ receives the data output from the first output terminal OA of the corresponding FIR filter 106_i, and outputs the data thus received to the corresponding first output port OUTAᵢ. Moreover, the second transmitter 108Bᵢ receives the data output from the second output terminal OB of the corresponding FIR filter 106_i, and outputs the data thus received to the corresponding second output port OUTBᵢ.

The forms of the receiver 102 and the transmitter 108 are not restricted in particular. As described later, in actual use, multiple audio signal processing circuits 100 may be connected. In a case in which data transmission between chips is performed in a parallel manner, the receivers 102 and the transmitters 108 may include a buffer that stores a corresponding bit respectively. In a case in which data transmission between chips is performed in a serial manner, each receiver 102 may be configured as a serial/parallel converter, and each transmitter 108 may be configured as a parallel/serial converter.

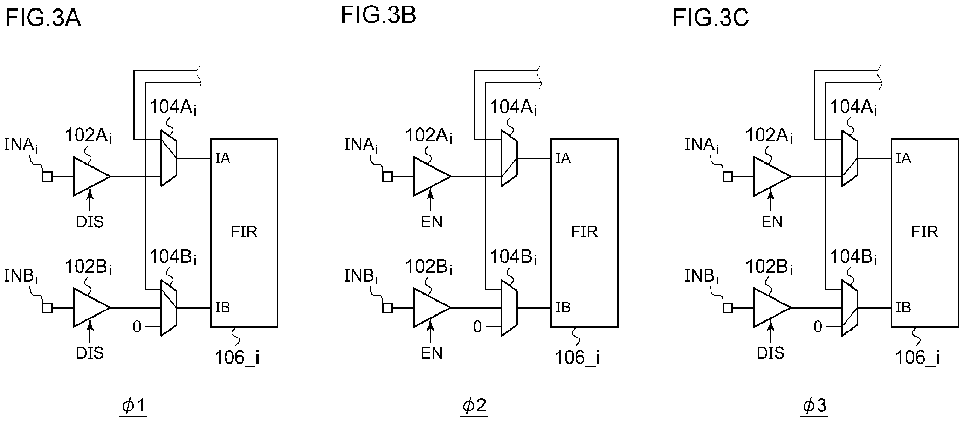

Figs. 3A through 3C are equivalent circuit diagrams showing the first state φ1 through the third state φ3.

The first receivers 102A and the second receivers 102B may each be configured to switch between being enabled and being disabled. In the first state φ1 shown in Fig. 3A, both the first receivers 102A and the second receivers 102B are each disabled. In the second state φ2 shown in Fig. 3B, both the first receivers 102A and the second receivers 102B are each enabled. In the third state φ3 shown in Fig. 3C, the first receivers 102A are each enabled, and the second receivers 102B are each disabled. By disabling the second receivers 102 when they are not required to operate, such an arrangement provides reduced power consumption.

Returning to Fig. 2, the output state of each FIR filter 106 is switchable between three states.

### (i) First state φx

In this state, the FIR filter 106_i outputs data from its output terminal OA to the output port OUTA, and outputs data from its output terminal OB to the output port OUTB.

### (ii) Second state φy

In this state, the FIR filter 106_i outputs data from its output terminals OA and OB to the adjacent FIR filter 106_(i+1).

### (iii) Third state φz

The data output from the output terminal OB of the FIR filter 106_i is output via the output port OUTB to a circuit external to the chip as the final data subjected to filtering.

In order to switch the state between the first state φx through the third state φz, the first transmitters 108A and the second transmitters 108B are configured to switch between being enabled and being disabled respectively. When the data output from the first terminal OA of the corresponding FIR filter 106_i is to be output to a circuit external to the chip via OUTAᵢ, the i-th transmitter 108Aᵢ is enabled. When the data output from the first output terminal OA of the corresponding FIR filter 106_i is to be supplied to the adjacent FIR filter 106_(i+1), the i-th transmitter 108Aᵢ is disabled. When the data output from the second output terminal OB of the corresponding FIR filter 106_i is to be output to a circuit external to the chip via OUTBᵢ, the i-th transmitter 108Bᵢ is enabled. When the data output from the second output terminal OB of the corresponding FIR filter 106_i is to be supplied to the adjacent FIR filter 106_(i+1), the i-th transmitter 108Bᵢ is disabled.

Accordingly, in the first state φx, the first transmitter 108Aᵢ and the second transmitter 108Bᵢ are both enabled. In the second state φy, the first transmitter 108Aᵢ and the second transmitter 108Bᵢ are both disabled. In the third state φz, the first transmitter 108Aᵢ is disabled, and the second transmitter 108Bᵢ is enabled. When a given transmitter is not required to operate, this transmitter is disabled, thereby providing reduced power consumption.

Description will be made regarding the number of bits of the audio data. In order to prevent overflow and underflow which can occur in the filtering calculation, the internal bit width of each FIR filter 106 is designed to be greater than that of the audio data. In a case in which the data output from the FIR filter 106_i via its second output terminal OB is used as the final output data of the FIR filter, this data is rounded so as to have the same bit width as that of the audio data. On the other hand, in a case in which this data is used as intermediate data to be input to another FIR filter, this data is output without rounding, i.e., with a bit width that is maintained to be greater than that of the audio data.

The above is the configuration of the audio signal processing circuit 100. Next, description will be made regarding examples of its usage.

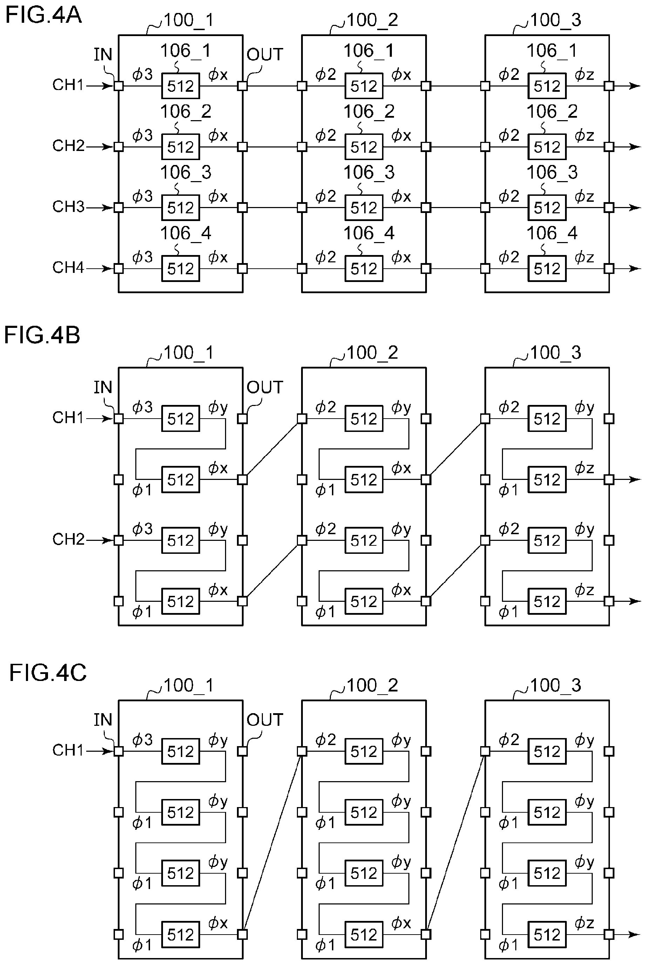

Figs. 4A through 4C are diagrams each showing examples of the usage of the audio signal processing circuit 100. In Figs. 4A through 4C, the receivers 102, the input multiplexers 104, and the transmitters 108 are not shown. The number shown for each FIR filter 106 represents the number of taps m of the FIR filter 106. A pair of the first input port INA and the second input port INB are collectively represented by "IN". A pair of the first output port OUTA and the second output port OUTB are collectively represented by "OUT".

Figs. 4A through 4C each show an arrangement in which three audio signal processing circuits 100 are used at the same time.

Description will be made with reference to Fig. 4A. In this usage example, the audio signals of four channels CH1 through CH4 are each processed by a FIR filter configured as a combination of three FIR filters connected in series so as to have 1536 taps. Specifically, three 1st FIR filters 106_1 respectively included in the audio signal processing circuits 100_1 through 100_3 are connected in series, so as to process the audio signal of the first channel CH1. Similarly, three 2nd FIR filters 106_2 are connected in series so as to process the audio signal of the second channel CH2. The audio signals of the third channel CH3 and the fourth channel CH4 are processed in the same way.

Description will be made with reference to Fig. 4B. In this usage example, the audio signals of two channels CH1 and CH2 are each processed by a FIR filter configured as a combination of six FIR filters connected in series so as to have 3072 taps. Specifically, six FIR filters 106_1 and 106_2, comprising two FIR filters 106_1 and 106_2 included in each of three audio signal processing circuits 100_1 through 100_3, are connected in series, so as to process the audio signal of the first channel CH1. Similarly, six FIR filters 106_3 and 106_4, comprising two FIR filters 106_3 and 106_4 included in each of three audio signal processing circuits 100_1 through 100_3, are connected in series, so as to process the audio signal of the second channel CH2.

Description will be made with reference to Fig. 4C. In this usage example, the audio signal of the first channel CH1 is processed by a FIR filter configured as a combination of twelve FIR filters connected in series so as to have 6144 taps.

As described above, by switching the state of the input side and the state of the output side of each FIR filter 106, such an arrangement is capable of supporting various numbers of channels and various required sound quality levels.

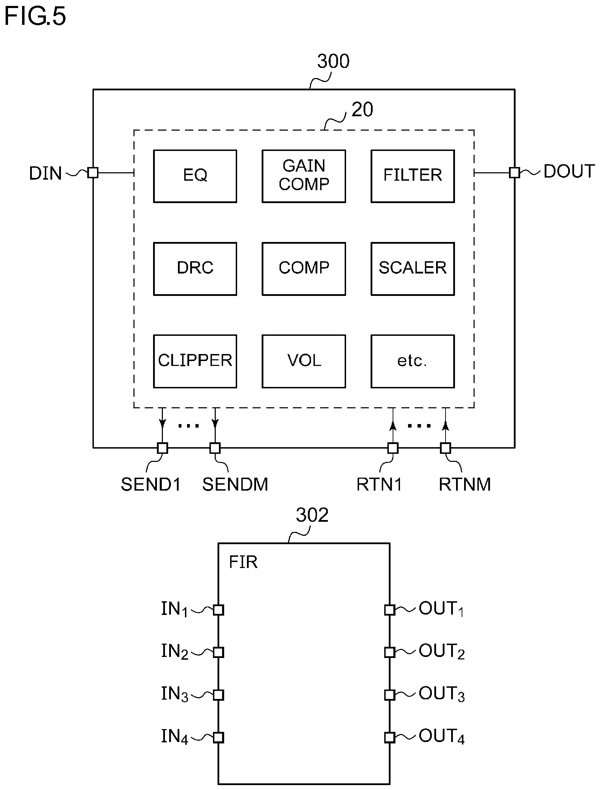

Fig. 5 is a block diagram showing an FIR chip 302 and a main audio signal processing circuit 300 to be operated together with the FIR chip 302. The FIR chip 302 includes the aforementioned audio signal processing circuit 100. The audio signal processing circuit 300 includes a block that corresponds to the digital signal processing unit 20 included in the DSP 4 shown in Fig. 1.

The audio signal processing circuit 300 includes M (M represents an integer) channels of send ports SEND1 through SENDM, and M channels of return ports RTN1 through RTNM.

The audio signal processing circuit 300 is capable of outputting, via the send ports SEND1 through SENDM, the M channels of audio signals to be processed by the digital signal processing unit 20. Furthermore, the audio signal processing circuit 300 is capable of receiving, via the return ports RTN1 through RTNM, the M channels of audio signals processed by an external circuit.

The audio signal processing circuit 300 can be operated in combination with at least one FIR chip 302. That is to say, the number of taps required for the FIR filter is determined based on the required sound quality. Furthermore, the number of required FIR chips 302 is determined based on the required number of taps and the number of channels. The set designer can purchase the required number of FIR chips 302 so as to provide an FIR filter having various kinds of configurations as shown in Figs. 4A through 4C. Next, the designer may preferably perform wiring such that the data output from the send ports SEND of the audio signal processing circuit 300 is input to the input terminals of the FIR filter, and such that the output signals of the FIR filter are returned to the return ports RTN of the audio signal processing circuit 300.

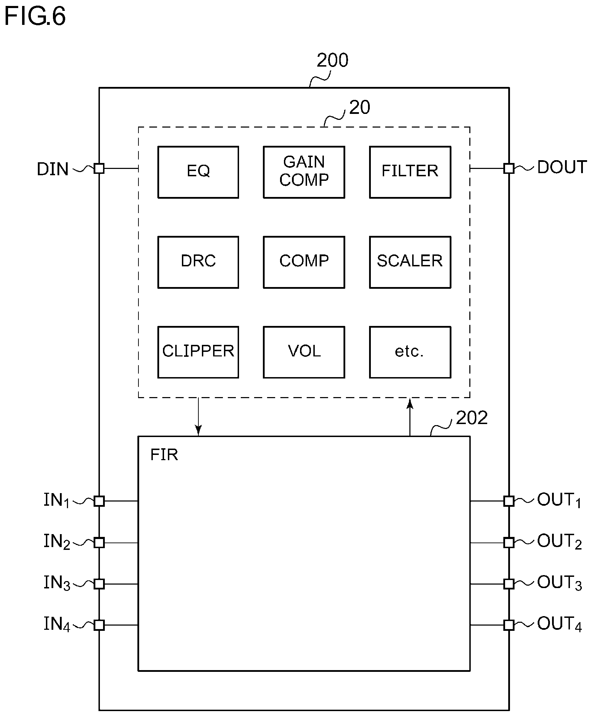

Fig. 6 is a block diagram showing an audio signal processing circuit 200. The audio signal processing circuit 200 includes a block that corresponds to the digital signal processing unit 20 of the DSP 4 shown in Fig. 1 and an FIR block 202. The FIR block 202 includes the aforementioned audio signal processing circuit 100.

As shown in Fig. 6, in a case in which a combination of the digital signal processing unit 20 and the FIR block 202 are consolidated as such a single module 200, the FIR block 202 is required to have a function of receiving an audio signal from the digital signal processing unit 20 and a function of returning an audio signal subjected to filtering to the digital signal processing unit 20.

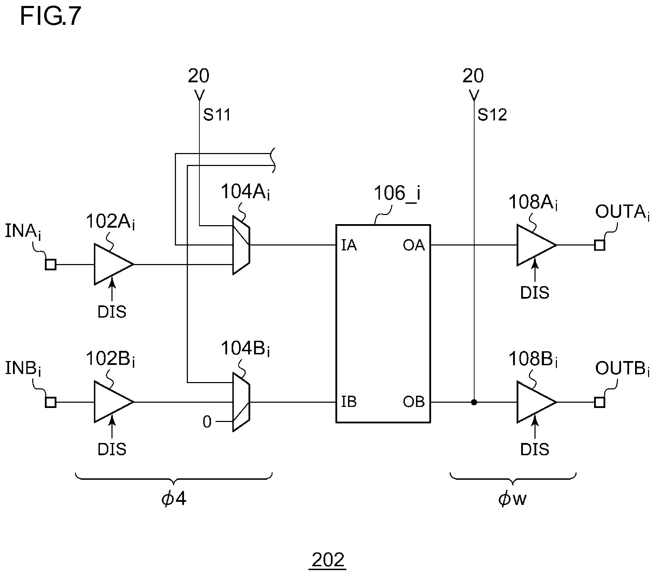

Fig. 7 is a diagram showing an example configuration of a part of the FIR block 202. An audio signal S11 is input from the digital signal processing unit 20 to the first input multiplexer 104A. When the audio signal output from the digital signal processing unit 20 is to be processed by the FIR filter 106_i, the input multiplexer 104 selects the signal S11. In this case, the second input multiplexer 104Bᵢ selects zero. Furthermore, the first receiver 102Aᵢ and the second receiver 102Bᵢ are both disabled. This state will be referred to as the "fourth state φ4".

In a case in which the FIR filter 106_i is selected as the final stage that outputs an output signal of the FIR filter 106, i.e., in a case in which the audio signal S12 subjected to filtering is returned to the digital signal processing unit 20, the first transmitter 108Aᵢ and the second transmitter 108Bᵢ are both disabled. This state will be referred to as the "fourth state φw".

By making a combination of multiple audio signal processing circuits 200 shown in Fig. 6, the scale of the FIR filter can be designed as desired according to the number of channels and the required sound quality.

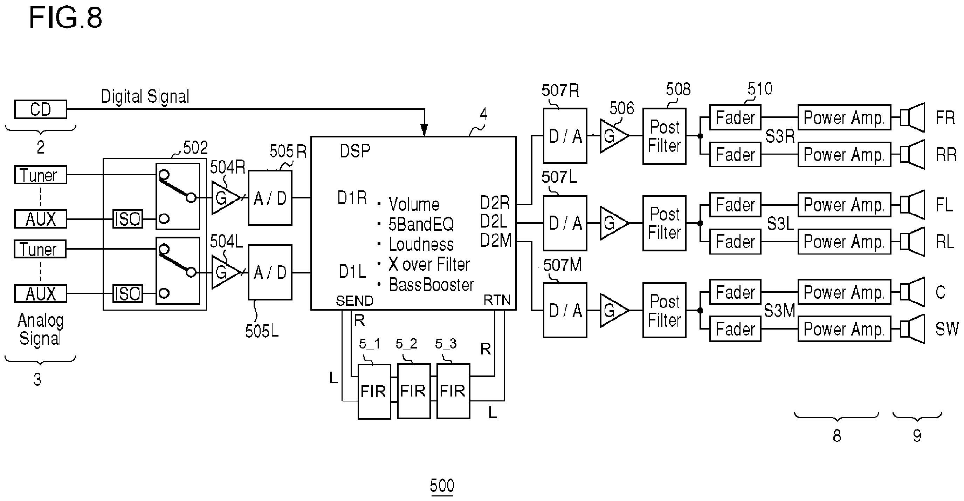

Next, description will be made regarding the usage of the audio system 1 employing the audio signal processing circuit 100. Fig. 8 is a block diagram showing a configuration of a car audio apparatus 500. The car audio apparatus 500 is configured as a 5.1 channel system (front right FR, rear right RR, front left FL, rear left RL, center C, subwoofer SW).

A digital sound source 2d is configured as a CD player or a DVD player. An analog sound source 3 is configured as a tuner or a mobile audio player.

A digital audio signal output from the digital sound source 2d is input to the digital input terminal of the DSP 4. A stereo (L-ch and R-ch) analog audio signal output from the tuner is input to TUNER channels. In addition, stereo analog audio signals, which can be output from other kinds of circuits such as a mobile audio player or the like, are input to AUX channels.

An input selector 502 and an amplifier 504 are provided for each of the R channel and the L channel. The input selector 502 selects the input channel (Tuner/AUX), and converts an analog audio signal output as a single-ended signal output from the selected channel into a differential signal. In a case in which an audio signal configured as a differential signal is input to the selected channel, the differential conversion processing is skipped.

An analog/digital converter 505R converts an input audio signal of the R channel configured as a differential signal into a digital audio signal D1R. An analog/digital converter 505L converts an input audio signal of the L channel configured as a differential signal into a digital audio signal D1L. In Fig. 7, a pair of the output signals D1R and D1L respectively output from the analog/digital converters 505L and 505R or otherwise the output of the digital sound source 2d corresponds to the digital audio signal S1 shown in Fig. 2.

The DSP 4 includes a digital volume circuit, a 5-band equalizer, a loudness control circuit, a crossover filter, and a bus booster circuit. The DSP 4 performs predetermined signal processing on an output signal of the digital sound source 2d or otherwise a pair of the output signals D1R and D1L respectively output from the analog/digital converters 505L and 505R. The DSP 4 corresponds to the audio signal processing circuit 300 shown in Fig. 5 or the audio signal processing circuit 200 shown in Fig. 6.

The DSP 4 outputs the audio signals of the L channel and the R channel via its send ports SEND. The DSP 4 is connected to multiple FIR chips 5_1 through 5_3. The FIR chips 5 correspond to the audio signal processing circuit 100 shown in Fig. 2, the FIR chip 302 shown in Fig. 5, or the audio signal processing circuit 200 shown in Fig. 6. The number of FIR chips 5 can be changed according to the required sound quality. For example, three FIR chips 5 may be connected in the same manner as shown in Fig. 4B.

The audio signals subjected to filtering are returned to the return ports RTN of the DSP 4. The DSP 4 performs remaining signal processing on the audio signal thus received, and outputs the audio signal of the L, R, and M channels. A D/A converter 507, an amplifier 506, and a post filter 508 are provided for each of the L, R, and M channels.

A D/A converter 507 is arranged for each channel, and converts an audio signal of the corresponding channel into an analog audio signal. The amplifier 506 amplifies an audio signal of the corresponding channel.

The three channels of audio signals are distributed to five channels respectively assigned to speakers via the post filter 508 and a fader volume 510. Power amplifiers 8 each amplify the corresponding audio signal so as to drive the speakers 9.

The audio signal processing circuit 100 according to the embodiment is suitably employed in such a car audio apparatus 500.

The application employing the audio signal processing circuit 100 is not restricted to such a car audio apparatus. Also, the audio signal processing circuit 100 is applicable to an audio component apparatus of a household audio system. Alternatively, the audio signal processing circuit 100 may be mounted on an electronic device such as a TV, a desktop PC, a laptop PC, a tablet PC, a cellular phone terminal, a digital still camera, a portable audio player, etc.

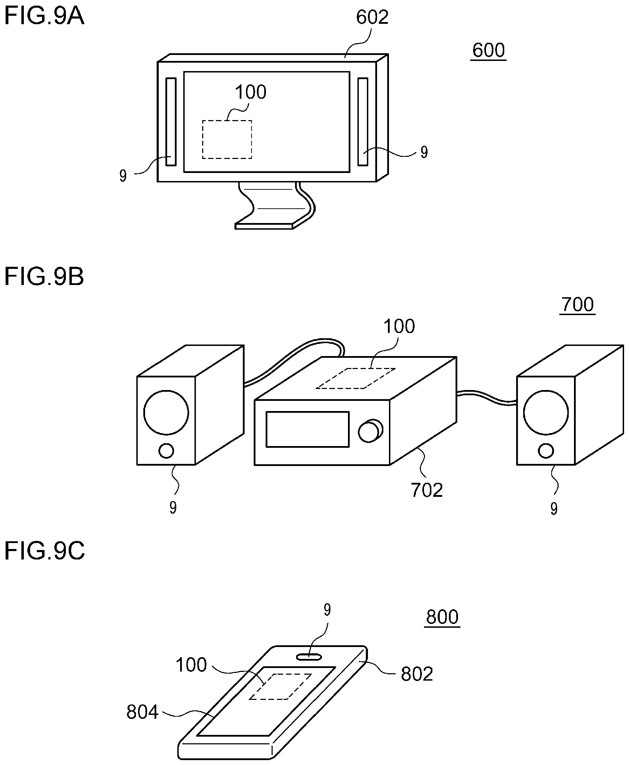

Figs. 9A through 9C are external views each showing an electronic device or otherwise an audio component apparatus. Fig. 9A shows a display apparatus 600 which is an example of an electronic device. The display apparatus 600 includes a housing 602 and speakers 9. The audio signal processing circuit 100 is built into the housing together with unshown components such as the DSP 4, the power amplifier 8, and the like.

Fig. 9B shows an audio component 700. The audio component 700 includes a housing 702 and speakers 9. The audio signal processing circuit 100 is built into the housing together with unshown components such as the DSP 4, the power amplifier 8, and the like.

Fig. 9C shows a compact information terminal 800 which is an example of an electronic device. The compact information terminal 800 is configured as a smartphone, cellular phone, PHS (Personal Handy-phone System), PDA (Personal Digital Assistant), tablet PC (Personal Computer), audio player, or the like. The compact information terminal 800 includes a housing 802, a speaker 9, and a display 804. The audio signal processing circuit 100 is built into the housing together with unshown components such as the DSP 4, the power amplifier 8, and the like.

The above-described embodiment has been described for exemplary purposes only, and is by no means intended to be interpreted restrictively. Rather, it can be readily conceived by those skilled in this art that various modifications may be made by making various combinations of the aforementioned components or processes, which are also encompassed in the technical scope of the present invention. Description will be made below regarding such modifications.

### [First modification]

Description has been made in the embodiment regarding an arrangement in which each second multiplexer 104B has a three-input configuration. However, other configurations may be employed. For example, each second receiver 102B may be configured to output zero in the disabled state, and each second input multiplexer 104B may be configured to select the output of the corresponding second receiver 102B in the third state φ3.

### [Second modification]

Also, as a mechanism for switching the state between the multiple states φ1 through φ3, a demultiplexer may be arranged on the output side of the FIR filter 106, instead of or otherwise in addition to employing the first input multiplexer 104A and the second input multiplexer 104B. Alternatively, such a multiplexer may also be substituted for an adder. That is to say, such a multiplexer that selects one from among signals A and B may be configured as an adder that adds the signals A and B. With such an arrangement, the signal other than the signal to be selected may be controlled to be zero.

### [Third modification]

Description has been made in the embodiment regarding an arrangement in which the controller 120 controls the internal state of the audio signal processing circuit 100. However, the present invention is not restricted to such an arrangement. Also, the state of each multiplexer and the state of each receiver may be set in an irreversible manner by means of memory employing fuses or otherwise using laser trimming.

Description has been made regarding the present invention with reference to the embodiments using specific terms. However, the above-described embodiments show only the mechanisms and applications of the present invention for exemplary purposes only, and are by no means intended to be interpreted restrictively. Rather, various modifications and various changes in the layout can be made without departing from the spirit and scope of the present invention defined in appended claims.

## Claims

1. An audio signal processing circuit (100) comprising:
a plurality of N (N represents an integer of 2 or more) FIR (Finite Impulse Response) filters (106);
a plurality of N first input ports (INA) that respectively correspond to the plurality of N FIR filters (106) ;
a plurality of N second input ports (INB) that respectively correspond to the plurality of N FIR filters (106) ;
a plurality of N first output ports (OUTA) that respectively correspond to the plurality of N FIR filters (106); and
a plurality of N second output ports (OUTB) that respectively correspond to the plurality of N FIR filters (106) ;
wherein the first input ports (INA), the second input ports (INB), the first output ports (OUTA), and the second output ports (OUTB) are integrated on a single semiconductor substrate,
wherein each FIR filter (106) comprises:
a first input terminal (IA);
a second input terminal (IB);
a first output terminal (OA);
a second output terminal (OB);
a plurality of m (m represents an integer of 2 or more) delay elements (d1-dm) connected in series between the first input terminal (IA) and the first output terminal (OA);
a plurality of multipliers (K1-Km) that multiply, by predetermined coefficient, data at a plurality of taps provided to the m delay elements (K1-Km); and
an adder circuit (107) that outputs, via the second output terminal (OB), product-sum data obtained by adding data input to the second input terminal (IB) and output data of the plurality of multipliers (K1-Km),
and wherein the i-th (2 ≤ i ≤ N) FIR filter (106_i) is configured to be switchable between:
(i) a state in which the i-th FIR filter (106_i) receives, at its first input terminal (IA), data output from the first output terminal (OA) of the (i-1)-th FIR filter (106_(i-1)), and receives, at its second input terminal (IB), data output from the second output terminal (OB) of the (i-1)-th FIR filter (106_(i-1));
(ii) a state in which the i-th FIR filter (106_i) receives, at its first input terminal (IA), data of the i-th first input port (INA), and receives, at its second input terminal (IB), data of the i-th second input port (INB); and
(iii) a state in which the i-th FIR filter (106_i) receives, at its first input terminal (IA), the data of the i-th first input port (INA), and receives zero at its second input terminal (IB).

2. The audio signal processing circuit (100) according to Claim 1, further comprising:
(N-1) first input multiplexers (104A₂-104A_{N}) that correspond to the 2nd through N-th FIR filters (106_2-106_N); and
(N-1) second input multiplexers (104B₂-104B_{N}) that correspond to the 2nd through N-th FIR filters (106_2-106_N),
wherein the i-th (2 ≤ i ≤ N) first input multiplexer (104Aᵢ) receives the data output from the first output terminal (OA) of the (i-1)-th FIR filter (106_(i-1)) and the data of the i-th first input port (INAᵢ), selects one from among the data thus received, and outputs the data thus selected to the first input terminal (IA) of the i-th FIR filter (106_i),
and wherein the i-th (2 ≤ i ≤ N) second input multiplexer (104Bᵢ) receives the data output from the second output terminal (OB) of the (i-1)-th FIR filter (106_(i-1)) and the data of the i-th second input port (INBᵢ), and outputs either one of the data thus received or otherwise zero to the second input terminal (IB) of the i-th FIR filter (106_i).

3. The audio signal processing circuit (100) according to Claim 2, further comprising a controller (120) that controls the (N-1) first input multiplexers (104A₂-104A_{N}) and the (N-1) second input multiplexers (104B₂-104B_{N}).

4. The audio signal processing circuit (100) according to any one of Claims 1 through 3, further comprising a 1st first multiplexer (104A₁) that corresponds to the 1st FIR filter (106_1),
and wherein the 1st first input multiplexer (104A₁) receives input data from another first circuit block included in the audio signal processing circuit (100) and data of the 1st first input port (INA₁), selects one from among the data thus received, and outputs the data thus selected to the first input terminal of the 1st FIR filter (106_1).

5. The audio signal processing circuit (100) according to any one of Claims 1 through 4, wherein at least one FIR filter (106) is configured such that the data output from its second output terminal (IB) can be supplied to another second circuit block included within the audio signal processing circuit (100).

6. The audio signal processing circuit (100) according to any one of Claims 1 through 5, further comprising:
N first receivers (102A) that correspond to the N first input ports (INA), each of which receives the data of the corresponding first input port (INA); and
N second receivers (102B) that correspond to the N second input ports (INB), each of which receives the data of the corresponding second input port (INB).

7. The audio signal processing circuit (100) according to Claim 6, wherein the first receivers (102A) and the second receivers (102B) each comprise a serial/parallel converter.

8. The audio signal processing circuit (100) according to Claim 6, wherein the first receivers (102A) and the second receivers (102B) each comprise a buffer that outputs parallel data.

9. The audio signal processing circuit (100) according to any one of Claims 1 through 8, further comprising:
N first transmitters (108A) that correspond to the N FIR filters (106), each of which receives data output from the first output terminal (OA) of the corresponding FIR filter (106), and outputs the received data to the corresponding first output port (OUTA); and
N second transmitters (108B) that correspond to the N FIR filters (106), each of which receives data output from the second output terminal (OB) of the corresponding FIR filter (106), and outputs the received data to the corresponding second output port (OUTB).

10. The audio signal processing circuit (100) according to Claim 9, wherein the first transmitters (108A) and the second transmitters (108B) each comprise a parallel/serial converter.

11. The audio signal processing circuit (100) according to Claim 9, wherein the first transmitters (108A) and the second transmitters (108B) each comprise a buffer that receives parallel data.

12. A car audio apparatus (500) comprising the audio signal processing circuit (100) according to any one of Claims 1 through 11.

13. An audio component apparatus (700) comprising the audio signal processing circuit (100) according to any one of Claims 1 through 11.

14. An electronic device (500) comprising the audio signal processing circuit (100) according to any one of Claims 1 through 11.

## Patentansprüche

1. Audiosignalverarbeitungsschaltung (100), umfassend umfasst:
mehrere N (N steht für eine ganze Zahl von mindestens 2) FIR (Finite Impulse Response)-Filter (106);
mehrere N erste Eingangsports (INA), die jeweils den mehreren N FIR-Filtern (106) entsprechen;
mehrere N zweite Eingangsports (INB), die jeweils den mehreren N FIR-Filtern (106) entsprechen;
mehrere N erste Ausgangsports (OUTA), die jeweils den mehreren N FIR-Filtern (106) entsprechen; und
mehrere N zweite Ausgangsports (OUTB), die jeweils den mehreren N FIR-Filtern (106) entsprechen;
wobei die ersten Eingangsports (INA), die zweiten Eingangsports (INB), die ersten Ausgangsports (OUTA) und die zweiten Ausgangsports (OUTB) auf einem einzelnen Halbleitersubstrat integriert sind,
wobei jedes FIR-Filter (106) umfasst:
einen ersten Eingangsanschluss (IA);
einen zweiten Eingangsanschluss (IB);
einen ersten Ausgangsanschluss (OA);
einen zweiten Ausgangsanschluss (OB);
mehrere m (m steht für eine ganze Zahl von mindestens 2) Verzögerungselemente (d1-dm), die zwischen dem ersten Eingangsanschluss (IA) und dem ersten Ausgangsanschluss (OA) in Reihe geschaltet sind;
mehrere Multiplikatoren (K1-Km), die Daten an mehreren Abgriffen, die an den m Verzögerungselementen (K1-Km) angeordnet sind, mit einem vorgegebenen Koeffizienten multiplizieren; und
eine Addierschaltung (107), die über den zweiten Ausgangsanschluss (OB) Produkt-Summe-Daten ausgibt, die durch Addieren von Daten, die in den zweiten Eingangsanschluss (IB) eingegeben werden, und Ausgangsdaten der mehreren Multiplikatoren (K1-Km) erhalten werden,
und wobei das i-te (2 ≤ i ≤ N) FIR-Filter (106_i) dafür ausgebildet ist, umgeschaltet werden zu können zwischen:
(i) einem Zustand, in dem das i-te FIR-Filter (106-i) an seinem ersten Eingangsanschluss (IA) Daten empfängt, die aus dem ersten Ausgangsanschluss (OA) des (i-1)-ten FIR-Filters (106_(i-1)) ausgegeben werden, und an seinem zweiten Eingangsanschluss (IB) Daten empfängt, die aus dem zweiten Ausgangsanschluss (OB) des (i-1)-ten FIR-Filters (106_(i-1)) ausgegeben werden;
(ii) einem Zustand, in dem das i-te FIR-Filter (106_i) an seinem ersten Eingangsanschluss (IA) Daten des i-ten ersten Eingangsports (INA) empfängt und an seinem zweiten Eingangsanschluss (IB) Daten des i-ten zweiten Eingangsports (INB) empfängt; und
(iii) einem Zustand, in dem das i-te FIR-Filter (106_i) an seinem ersten Eingangsanschluss (IA) die Daten des i-ten ersten Eingangsports (INA) empfängt und null an seinem zweiten Eingangsanschluss (IB) empfängt.

2. Audiosignalverarbeitungsschaltung (100) nach Anspruch 1, des Weiteren umfassend:
(N-1) erste Eingangsmultiplexierer (104A₂-104A_{N}), die den 2. bis N-ten FIR-Filtern (106_2-106_N) entsprechen; und (N-1) zweite Eingangsmultiplexierer (104B₂-104B_{N}), die den 2. bis N-ten FIR-Filtern (106_2-106_N) entsprechen,
wobei der i-te (2 ≤ i ≤ N) erste Eingangsmultiplexierer (104Aᵢ) die Daten, die aus dem ersten Ausgangsanschluss (OA) der (i-1)-ten FIR-Filters (106_(i-1)) ausgegeben werden, und die Daten des i-ten ersten Eingangsports (INAᵢ) empfängt, ein Datenelement aus den auf diese Weise empfangenen Daten auswählt, und die auf diese Weise ausgewählten Daten an den ersten Eingangsanschluss (IA) des i-ten FIR-Filters (106_i) ausgibt,
und wobei der i-te (2 ≤ i ≤ N) zweite Eingangsmultiplexierer (104Bᵢ) die Daten, die aus dem zweiten Ausgangsanschluss (OB) des (i-1)-ten FIR-Filters (106_(i-1)) ausgegeben werden, und die Daten des i-ten zweiten Eingangsports (INBᵢ) empfängt und entweder eines der auf diese Weise empfangenen Daten oder anderenfalls null an den zweiten Eingangsanschluss (IB) des i-ten FIR-Filters (106_i) ausgibt.

3. Audiosignalverarbeitungsschaltung (100) nach Anspruch 2, die des Weiteren eine Steuereinheit (120) umfasst, die die (N-1) ersten Eingangsmultiplexierer (104A₂-104A_{N}) und die (N-1) zweiten Eingangsmultiplexierer (104B₂-104B_{N}) steuert.

4. Audiosignalverarbeitungsschaltung (100) nach einem der Ansprüche 1 bis 3, die des Weiteren einen 1. ersten Multiplexierer (104Aᵢ) umfasst, der dem 1. FIR-Filter (106_1) entspricht,
und wobei der 1. erste Eingangsmultiplexierer (104A1) Eingangsdaten von einem anderen ersten Schaltungsblock, der in der Audiosignalverarbeitungsschaltung (100) enthalten ist, und Daten des 1. ersten Eingangsports (INA₁) empfängt, eines unter den auf diese Weise empfangenen Daten auswählt, und die auf diese Weise ausgewählten Daten an den ersten Eingangsanschluss des 1. FIR-Filters (106_1) ausgibt.

5. Audiosignalverarbeitungsschaltung (100) nach einem der Ansprüche 1 bis 4, wobei mindestens ein FIR-Filter (106) so konfiguriert ist, dass die von seinem zweiten Ausgangsanschluss (IB) ausgegebenen Daten an einen anderen zweiten Schaltungsblock übermittelt werden können, der in der Audiosignalverarbeitungsschaltung (100) enthalten ist.

6. Audiosignalverarbeitungsschaltung (100) nach einem der Ansprüche 1 bis 5, des Weiteren umfassend:
N erste Empfänger (102A), die den N ersten Eingangsports (INA) entsprechen, von denen jeder die Daten des entsprechenden ersten Eingangsports (INA) empfängt; und
N zweite Empfänger (102B), die den N zweiten Eingangsports (INB) entsprechen, von denen jeder die Daten des entsprechenden zweiten Eingangsports (INB) empfängt.

7. Audiosignalverarbeitungsschaltung (100) nach Anspruch 6, wobei die ersten Empfänger (102A) und die zweiten Empfänger (102B) jeweils einen Seriell-Parallel-Wandler umfassen.

8. Audiosignalverarbeitungsschaltung (100) nach Anspruch 6, wobei die ersten Empfänger (102A) und die zweiten Empfänger (102B) jeweils einen Puffer umfassen, der parallele Daten ausgibt.

9. Audiosignalverarbeitungsschaltung (100) nach einem der Ansprüche 1 bis 8, des Weiteren umfassend:
N erste Sender (108A), die den N FIR-Filtern (106) entsprechen, von denen jeder Daten empfängt, die aus dem ersten Ausgangsanschluss (OA) des entsprechenden FIR-Filters (106) ausgegeben werden, und die empfangenen Daten an den entsprechenden ersten Ausgangsport (OUTA) ausgibt; und
N zweite Sender (108B), die den N FIR-Filtern (106) entsprechen, von denen jeder Daten empfängt, die aus dem zweiten Ausgangsanschluss (OB) des entsprechenden FIR-Filters (106) ausgegeben werden, und die empfangenen Daten an den entsprechenden zweiten Ausgangsport (OUTB) ausgibt.

10. Audiosignalverarbeitungsschaltung (100) nach Anspruch 9, wobei die ersten Sender (108A) und die zweiten Sender (108B) jeweils einen Parallel-Seriell-Wandler umfassen.

11. Audiosignalverarbeitungsschaltung (100) nach Anspruch 9, wobei die ersten Sender (108A) und die zweiten Sender (108B) jeweils einen Puffer umfassen, der parallele Daten empfängt.

12. Kraftfahrzeug-Audiovorrichtung (500), die eine Audiosignalverarbeitungsschaltung (100) nach einem der Ansprüche 1 bis 11 umfasst.

13. Audiokomponentenvorrichtung (700), die eine Audiosignalverarbeitungsschaltung (100) nach einem der Ansprüche 1 bis 11 umfasst.

14. Elektronische Vorrichtung (500), die eine Audiosignalverarbeitungsschaltung (100) nach einem der Ansprüche 1 bis 11 umfasst.

## Revendications

1. Circuit de traitement de signal audio (100) comprenant :
une pluralité de N (N représente un nombre entier supérieur ou égal à 2) filtres FIR (*finite impulse response,* à réponse impulsionnelle finie) (106) ;
une pluralité de N premiers accès d'entrée (INA) qui correspondent respectivement à la pluralité de N filtres FIR (106) ;
une pluralité de N seconds accès d'entrée (INB) qui correspondent respectivement à la pluralité de N filtres FIR (106) ;
une pluralité de N premiers accès de sortie (OUTA) qui correspondent respectivement à la pluralité de N filtres FIR (106) ; et
une pluralité de N seconds accès de sortie (OUTB) qui correspondent respectivement à la pluralité de N filtres FIR (106) ;
dans lequel les premiers accès d'entrée (INA), les seconds accès d'entrée (INB), les premiers accès de sortie (OUTA) et les seconds accès de sortie (OUTB) sont intégrés sur un seul substrat semi-conducteur,
dans lequel chaque filtre FIR (106) comprend :
une première borne d'entrée (IA) ;
une seconde borne d'entrée (IB) ;
une première borne de sortie (OA) ;
une seconde borne de sortie (OB) ;
une pluralité de m (m représente un nombre entier supérieur ou égal à 2) éléments à retard (d1 à dm) montés en série entre la première borne d'entrée (IA) et la première borne de sortie (OA) ;
une pluralité de multiplicateurs (K1 à Km) qui multiplient, par un coefficient prédéterminé, des données à une pluralité de prises se trouvant sur les m éléments à retard (K1 à Km) ; et
un circuit d'addition (107) qui délivre en sortie, par l'intermédiaire de la seconde borne de sortie (OB), des données de somme des produits, obtenues par addition des données appliquées à la seconde borne d'entrée (IB) et des données de sortie de la pluralité de multiplicateurs (K1 à Km),
et dans lequel le i^{ième} (2 ≤ i ≤ N) filtre FIR (106_i) est conçu pour être commutable entre :
(i) un état dans lequel le i^{ième} filtre FIR (106_i) reçoit, à sa première borne d'entrée (IA), des données délivrées depuis la première borne de sortie (OA) du (i-1)^{ième} filtre FIR (106 (i-1)), et reçoit, à sa seconde borne d'entrée (IB), des données délivrées depuis la seconde borne de sortie (OB) du (i-1)^{ième} filtre FIR (106_(i-1)) ;
(ii) un état dans lequel le i^{ième} filtre FIR (106_i) reçoit, à sa première borne d'entrée (IA), des données du i^{ième} premier accès d'entrée (INA), et reçoit, à sa seconde borne d'entrée (IB), des données du i^{ième} second accès d'entrée (INB) ; et
(iii) un état dans lequel le i^{ième} filtre FIR (106_i) reçoit, à sa première borne d'entrée (IA), les données du i^{ième} premier accès d'entrée (INA), et reçoit zéro à sa seconde borne d'entrée (IB).

2. Circuit de traitement de signal audio (100) selon la revendication 1, comprenant en outre :
(N-1) premiers multiplexeurs d'entrée (104A₂ à 104A_{N}) qui correspondent aux 2^{d} à N^{ième} filtres FIR (106_2 à 106_N) ; et
(N-1) seconds multiplexeurs d'entrée (104B₂ à 104B_{N}) qui correspondent aux 2^{d} à N^{ième} filtres FIR (106_2 à 106_N), dans lequel le i^{ième} (2 ≤ i ≤ N) premier multiplexeur d'entrée (104Aᵢ) reçoit les données délivrées depuis la première borne de sortie (OA) du (i-1)^{ième} filtre FIR (106_(i-1)) et les données du i^{ième} premier accès d'entrée (INAᵢ), sélectionne des données parmi celles ainsi reçues, et délivre les données ainsi sélectionnées à la première borne d'entrée (IA) du i^{ième} filtre FIR (106_i),
et dans lequel le i^{ième} (2 ≤ i ≤ N) second multiplexeur d'entrée (104Bᵢ) reçoit les données délivrées depuis la seconde borne de sortie (OB) du (i-1)^{ième} filtre FIR (106_(i-1)) et les données du i^{ième} second accès d'entrée (INBᵢ), et délivre les unes ou les autres des données ainsi reçues ou encore zéro à la seconde borne d'entrée (IB) du i^{ième} filtre FIR (106_i).

3. Circuit de traitement de signal audio (100), selon la revendication 2, comprenant en outre un dispositif de commande (120) qui commande les (N-1) premiers multiplexeurs d'entrée (104A₂ à 104A_{N}) et les (N-1) seconds multiplexeurs d'entrée (104B₂ à 104B_{N}).

4. Circuit de traitement de signal audio (100) selon l'une quelconque des revendications 1 à 3, comprenant en outre un 1^{er} premier multiplexeur (104A₁) qui correspond au 1^{er} filtre FIR (106_1),
dans lequel le 1^{er} premier multiplexeur d'entrée (104A₁) reçoit des données d'entrée en provenance d'un autre premier bloc de circuits inclus dans le circuit de traitement de signal audio (100) et des données du 1^{er} premier accès d'entrée (INA₁), sélectionne des données parmi celles ainsi reçues, et délivre les données ainsi sélectionnées à la première borne d'entrée du 1^{er} filtre FIR (106_1).

5. Circuit de traitement de signal audio (100) selon l'une quelconque des revendications 1 à 4, dans lequel au moins un filtre FIR (106) est conçu de manière que les données délivrées depuis sa seconde borne de sortie (IB) puissent être fournies à un autre second bloc de circuits inclus à l'intérieur du circuit de traitement de signal audio (100).

6. Circuit de traitement de signal audio (100) selon l'une quelconque des revendications 1 à 5, comprenant en outre :
N premiers récepteurs (102A) qui correspondent aux N premiers accès d'entrée (INA), dont chacun reçoit les données du premier accès d'entrée correspondant (INA) ; et
N seconds récepteurs (102B) qui correspondent aux N seconds accès d'entrée (INB), dont chacun reçoit les données du second accès d'entrée (INB) correspondant.

7. Circuit de traitement de signal audio (100) selon la revendication 6, dans lequel les premiers récepteurs (102A) et les seconds récepteurs (102B) comprennent chacun un convertisseur série-parallèle.

8. Circuit de traitement de signal audio (100) selon la revendication 6, dans lequel les premiers récepteurs (102A) et les seconds récepteurs (102B) comprennent chacun un tampon qui délivre des données parallèles.

9. Circuit de traitement de signal audio (100) selon l'une quelconque des revendications 1 à 8, comprenant en outre :
N premiers émetteurs (108A) qui correspondent aux N filtres FIR (106), dont chacun reçoit des données délivrées depuis la première borne de sortie (OA) du filtre FIR (106) correspondant, et délivre les données reçues au premier accès de sortie (OUTA) correspondant ; et
N seconds émetteurs (108B) qui correspondent aux N filtres FIR (106), dont chacun reçoit des données délivrées depuis la seconde borne de sortie (OB) du filtre FIR (106) correspondant, et délivre les données reçues au second accès de sortie (OUTB) correspondant.

10. Circuit de traitement de signal audio (100) selon la revendication 9, dans lequel les premiers émetteurs (108A) et les seconds émetteurs (108B) comprennent chacun un convertisseur parallèle-série.

11. Circuit de traitement de signal audio (100) selon la revendication 9, dans lequel les premiers émetteurs (108A) et les seconds émetteurs (108B) comprennent chacun un tampon qui reçoit des données parallèles.

12. Appareil audio de voiture (500) comprenant le circuit de traitement de signal audio (100) selon l'une quelconque des revendications 1 à 11.

13. Appareil à composants audio (700) comprenant le circuit de traitement de signal audio (100) selon l'une quelconque des revendications 1 à 11.

14. Dispositif électronique (500) comprenant le circuit de traitement de signal audio (100) selon l'une quelconque des revendications 1 à 11.
